(19) Europäisches Patentamt
European Patent Office
Office européen des brevets

(11) **EP 0 695 005 B1**

(12) **EUROPEAN PATENT SPECIFICATION**

(45) Date of publication and mention
of the grant of the patent:
**26.06.2002  Bulletin 2002/26**

(51) Int Cl.[7]: **H01S 5/32**

(21) Application number: **95115694.2**

(22) Date of filing: **15.04.1993**

(54) **Semiconductor laser device**

Halbleiterlaservorrichtung

Dispositif laser à semi-conducteur

(84) Designated Contracting States:
**DE GB**

(30) Priority: **15.04.1992  JP  9557992**
**15.04.1992  JP  9558092**

(43) Date of publication of application:
**31.01.1996  Bulletin 1996/05**

(62) Document number(s) of the earlier application(s) in
accordance with Art. 76 EPC:
**93302936.5 / 0 566 411**

(73) Proprietors:
• **SHARP KABUSHIKI KAISHA**
**Osaka-shi, Osaka-fu 545-0013 (JP)**
• **THE FURUKAWA ELECTRIC CO., LTD.**
**Tokyo 100 (JP)**

(72) Inventors:
• **Okumura, Toshiyuki**
**Tenri-shi, Nara-ken (JP)**
• **Konushi, Fumihiro**
**Nara-shi, Nara-ken (JP)**
• **Morioka,Tatsuya**
**Nara-shi, Nara 631 (JP)**
• **Matsumoto,Narihito**
**Ichihara-shi, Chiba 290 (JP)**

(74) Representative: **Suckling, Andrew Michael et al**
**Marks & Clerk,**
**Nash Court,**
**Oxford Business Park South**
**Oxford OX4 2RU (GB)**

(56) References cited:
• **TRANSACTIONS OF THE INSTITUTE OF ELECTRONICS AND COMMUNICATION ENGINEERS OF JAPAN, SECTION E, vol. E73, no. 1, January 1990 TOKYO JP, pages 59-62, A. KASUKAWA ET AL 'Effect of well number in 1.3 mum GaInAsP graded index separate confinement heterostructure multiple quantum well (GRINSCH-SCH-MQW) laser diodes'**
• **PROCEEDINGS OF THE INTERNATIONAL CONFERENCE ON INDIUM PHOSPHIDE AND RELATED MATERIALS, NEWPORT, APR. 21 - 24, 1992, no. CONF. 4, INSTITUTE OF ELECTRICAL AND ELECTRONICS ENGINEERS, pages 465-468, XP 000341299 IKUO MITO ET AL 'HIGH POWER QUANTUM WELL LASERS FOR FIBER AMPLIFIER EXCITATION'**
• **IEEE JOURNAL OF QUANTUM ELECTRONICS, vol. qe-21, no. 12, December 1985 NEW YORK US, pages 1958-1963, P.W.A MC ILROY ET AL 'Analysis and application of theoretical gain curves to the design of multi quantum well lasers'**
• **P.BLOOD ET AL APPLIED PHYSICS LETTERS vol. 47, no. 3, August 1985, USA, pages 193 - 195**
• **N. MATSUMOTO ET AL IEEE JOURNAL OF QUANTUM ELECTRONICS vol. 27, no. 6, June 1991, USA, pages 1958 - 1963**

## Description

The present invention relates to semiconductor lasers and, more particularly, to semiconductor lasers having a quantum well structure which can be used for fiber optic communication, information processing utilizing light, and the like.

This is a divisional application from European patent application No. 0 566 411.

Semiconductor laser devices having a quantum well structure of compound semiconductor material are, based on theoretical studies, expected to have excellent characteristics of performance such as a low threshold value, high conversion efficiency and small temperature dependency. Recently, intensive efforts have been made for research and development of these devices.

A quantum well semiconductor laser device is generally known to have the following structural features. A quantum well structure is interposed between a pair of guide layers and serves as a resonator of the laser device. The quantum well structure includes at least one quantum well layer and at least one barrier layer. The thickness of the quantum well layer is set sufficiently thin to generate quantum effect for electrons injected into the quantum well structure.

The above-mentioned advantages of quantum well semiconductor laser devices are based on the following theory. That is, because such a device allows diffusion of electrons only in directions in two dimensions and thus forms quantum levels within the quantum well layer, changes in density of states of electrons would be more abrupt and gain distribution generated by electrons would be more restricted than in the case of semiconductor laser devices having conventional double heterostructures wherein electrons diffuse in directions in three dimensions. On the other hand, because holes have heavier mass and thus smaller energy differences among existing quantum levels compared with the case of electrons, quantum effect is usually not significantly attained for holes within the quantum well structure. Therefore, characteristics of a quantum well semiconductor laser device are mainly affected by density of states of electrons.

The above-mentioned abrupt changes in density of states of electrons are known to be shown by electrons in all quantum levels, regardless of the number of quantum well layers and the length of the resonator of a semiconductor laser device. For this reason, the number of quantum levels allowed to exist within the quantum well structure, as well as the number of quantum well layers and the length of the resonator, have attracted little or no specific attention in studies for manufacturing quantum well semiconductor laser devices.

However, conventional quantum well semiconductor laser devices have not shown as good characteristics as have been expected. For example, semiconductor laser devices for household machines, such as those used for fiber optic communication between a telephone central office and the homes of subscribers, are often used under rigorous conditions and thus especially require satisfactory performance characteristics at high temperature. Nonetheless, conventional quantum well semiconductor laser devices to date have not satisfactorily realized desired characteristics such as those enabling laser oscillation at significantly high temperature while preventing saturation of optical output. This particular problem is believed to be caused because of the following reason. That is, as temperature of the semiconductor laser device rises and a threshold current density required for attaining laser oscillation increases, carriers injected into a quantum well layer overflow to an adjacent barrier layer, thereby further accelerating increase in the threshold current density.

To overcome the above-mentioned problem, attempts have been made to coat the faces of the resonator of a quantum well semiconductor laser device with dielectric layers having high reflectivity. Such coating can reduce the threshold current density and thus enables laser oscillation at higher temperature. However, these semiconductor laser devices are difficult to use for generating optical output of significantly high intensity.

Further, when used as a component in a fiber optic communication system, a semiconductor laser device is usually coupled with an optical fiber through a lens interposed therebetween. In order to improve transmission characteristics of the system, the semiconductor laser device should have high coupling efficiency with the optical fiber. It is known that achievement of higher coupling efficiency makes it desirable for laser light emitted from the semiconductor laser device to have a circular image rather than an elliptic image along a plane parallel to the light emitting face of the device. Therefore, this desired characteristic would preferably be incorporated into structural features of quantum well semiconductor laser devices.

"Transactions of the IEICE" Vol. E73, No. 1, pp. 59-62 (1990) reports an investigation into the effect of varying the number of quantum wells in the MQW active region of a laser device. The investigation concludes that the optimum number of quantum wells is 4 or 5.

"Applied Physics Letters" Vol. 47, No. 3 pp. 193-195 (1985) reports an investigation into the properties of a laser device as the number of quantum wells in the MQW active region is varied. The investigation concludes that the threshold current of the laser device increases as the number of quantum wells in the active region is increased.

"IEEE Journal of Quantum Electronics" Vol. 27, No. 6 pp. 1790-1793 (1991) reports the results of a study of SQW laser devices. Some results on MQW laser devices are included for comparison.

The present invention according to claim 1 provides a semiconductor laser device having a resonator, the device comprising: a substrate; and a laminated structure formed on a top face of the substrate, the laminated structure including (a) first and second guide layers and (b) a quantum well structure of compound semiconductor interposed between the first and second guide layers, the quantum well structure serving as the resonator and including a plurality of quantum well layers and a plurality of barrier layers stacked in alternating manner; wherein the number of the quantum well layers is in the range of 6 to 10, and the length of the resonator is in the range of 250µm to 700µm; and the thicknesses of the first and second guide layers are selected to give laser light emitted from the device a perpendicular spreading angle in the range of about 25° to about 30°.

The invention described herein makes possible, among others, the advantages of (1) improving temperature characteristics of a quantum well semiconductor laser device by reducing overflow of carriers and obtaining sufficient optical output when the device is operated at high temperature; and (2) enabling a quantum well semiconductor laser device to realize high coupling efficiency with an optical fibre and the like.

These and other advantages of the present invention will become apparent to those skilled in the art upon reading and understanding the following detailed description with reference to the accompanying drawings.

## BRIEF DESCRIPTION OF THE DRAWINGS

Figure **1** is a schematic perspective view illustrating an embodiment of a semiconductor laser device according to the present invention.

Figure **2** is a conceptual view illustrating the energy band structure of and around the quantum well structure of the semiconductor laser device of Figure 1.

Figure **3** is a graph illustrating variation of threshold current densities of semiconductor laser devices, as functions of the length of the resonator and the number of the quantum well layers, where the semiconductor laser devices are made of InGaAsP/InP type materials and have guide layers with a GRIN-SCH structure.

Figure **4a** is a schematic view illustrating an angle φ measured from the perpendicular line which is perpendicular to a light emitting face of a semiconductor laser device.

Figure **4b** is a graph illustrating a relationship between the angle φ and intensity of emitted laser light in view of determining the spreading angle θ of laser light.

Figure **5** is a graph illustrating relationships between the spreading angle e and the thickness of the guide layers for semiconductor laser devices having varied number of quantum well layers.

Figure **6** is a graph illustrating a distribution of electrons at an exemplary high temperature condition which are injected into a quantum well structure which allows for two quantum levels to exist therein.

## DESCRIPTION OF THE PREFERRED EMBODIMENTS

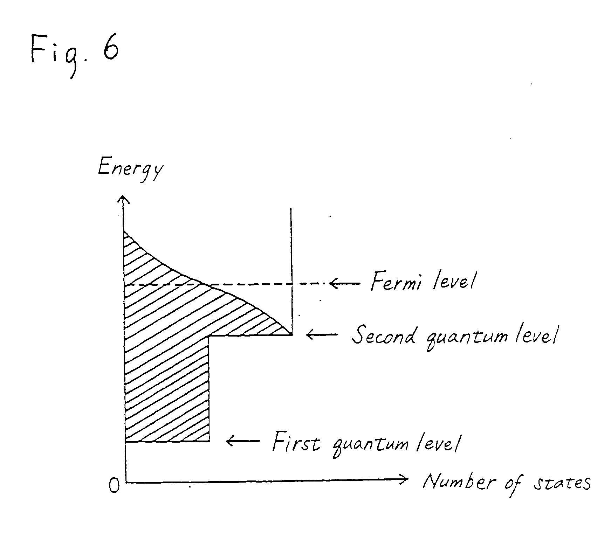

A quantum well semiconductor laser device generally has a low threshold current density at around room temperature and thus oscillates laser light even with a relatively small amount of injected carriers. Such a laser oscillation has a wavelength corresponding to the lowest quantum level (n=1) of electrons even where the quantum well structure allows for more than two quantum levels to exist therein. As the temperature of the semiconductor laser device rises and accordingly the threshold current density increases, however, injected carriers are also placed in the second lowest quantum level (n=2) and laser oscillation begins with a wavelength corresponding to the second lowest quantum level. Figure **6** illustrates a distribution of electrons in such a situation (i.e., when the quantum well semiconductor laser device is operated at high temperature). This distribution is obtained as a product of Fermi distribution function and density of states of electrons. As is represented in Figure **6**, under high temperature conditions there is an increased number of electrons having higher energy, which would overflow from a quantum well layer to an adjacent barrier layer, thereby further accelerating the increase of the threshold current density.

According to an example of a semiconductor laser device, a thickness $L_z$ of a quantum well layer within the quantum well structure and the energy difference $V_0$ between the bottom of the conduction band of the quantum well layer and the bottom of the conduction band of an adjacent barrier layer satisfy the relationship represented by formula (I):

$$L_z \leq h / 2 \, (2m^*v_0)^{1/2} \qquad \text{(I)}$$

wherein h is Planck's constant and m* is the effective mass of electrons within the quantum well layer. When this relationship is satisfied, the quantum well structure allows only for the lowest quantum level (n=1) to exist therein. Therefore, even when operated at high temperature, a semiconductor laser device of this type does not oscillate with a wavelength corresponding to the second lowest quantum level, and thus can restrict the overflow of carriers.

According to an example of a semiconductor laser device of this invention, the number of the quantum well layers within a quantum well structure is set in the range of 6 to 10, and the length of the resonator of the device is set in the range of 250 µm to 700 µm. By selecting the parameters of semiconductor laser device in the specified range, improved temperature characteristics of the device are obtained and, at the same time, high coupling efficiency of the device with optical fiber and the like is facilitated.

Example 1

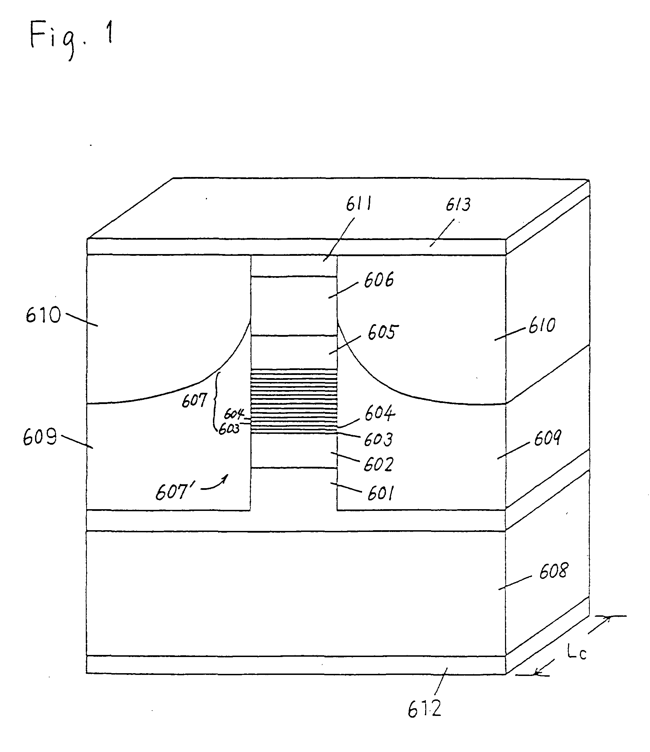

With reference to Figure **1**, a schematic perspective view of an embodiment of a semiconductor laser device according to the present invention is illustrated.

The semiconductor laser device of Figure **1** has a substrate **608** made of n-type InP and a laminated structure formed on the top face of the substrate **608**. The laminated structure includes, in the direction away from the substrate **608**, an n-cladding layer **601** made of n-type InP, a first guide layer **602** having a four-layer GRIN-SCH structure made of InGaAsP ($\lambda_g$ = 0.95, 1.0, 1.05 and 1.1 µm for the respective layers in the direction away from the n-cladding layer **601**; thickness in total = 100 nm), an active layer **607** having a quantum well structure, a second guide layer **605** having a four-layer GRIN-SCH structure made of InGaAsP ($\lambda_g$ = 1.1, 1.05, 1.0 and 0.95 µm for the respective layers in the direction away from the active layer **607**; thickness in total = 100 nm), a p-cladding layer **606** made of p-type InP, and a p$^+$-cap layer **611** made of p$^+$-type InGaAsP ($\lambda_g$ = 1.3 µm). Within the active layer **607**, a plurality of quantum well layers **603** each made of InGaAsP ($\lambda_g$ = 1.37 µm; thickness = 8 nm), and a plurality of barrier layers **604** each made of InGaAsP ($\lambda_g$ = 1.1 µm; thickness = 12 nm) are stacked in alternating manner. In this example, the active layer **607** has nine (9) quantum well layers **603** and eight (8) barrier layers **604**.

The above laminated structure is obtained by sequentially growing on the substrate **608** each of the layers **601**, **602**, **607**, **605**, **606** and **611** by use of conventional epitaxial growth method. The laminated structure is then subjected to etching treatment to form a stripe-shaped portion **607'**. This stripe-shaped portion is provided on both of its side faces with a current blocking layer including a p-type InP layer **609** and an n-type InP layer **610** in a manner as shown in Figure **1**. An electrode **612** is formed on the bottom face of the substrate **608**, and another electrode **613** is formed to be in contact with the p$^+$-cap layer **611** and the n-type InP layer **610**, thereby resulting in the semiconductor laser device of this example. In this semiconductor laser device, the active layer **607** which serves as the resonator has the length $L_c$ of 350 µm along the direction of the resonator, as shown in Figure **1**.

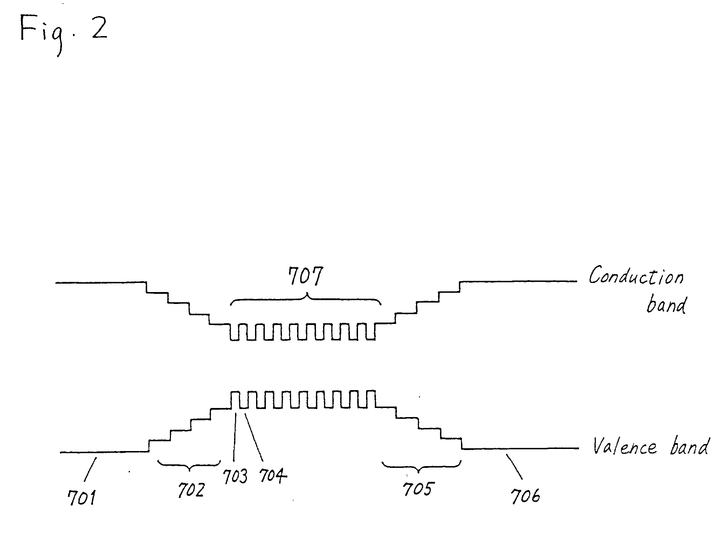

Figure **2** illustrates the energy band structure of and around the active layer of the above semiconductor laser device.

An energy band of the portion **707** of the energy band structure in Figure **2** corresponds to the energy band of the active layer **607** in Figure **1**. Further in Figure **2**, energy bands **701**, **702**, **703**, **704**, **705** and **706** respectively represent the energy bands of the n-cladding layer **601**, the first guide layer **602**, the quantum well layer **603**, the barrier layer **604**, the second guide layer **605** and the p-cladding layer **606**. The stepwise changes shown in the energy bands **702** and **705** reflect the GRIN-SCH structures of the first guide layer **602** and the second guide layer **605**. However, the semiconductor laser device of this example may include a guide layer having uniform composition ratio along the transverse direction of the layer.

As mentioned above, the quantum well semiconductor laser device of this example has nine (9) quantum well layers and the resonator length of 350 µm. However, advantages of this invention are most preferably realized as long as a quantum well semiconductor laser device has the number of the quantum well layers in the range of 6 to 10, and the resonator length in the range of 250 µm to 700 µm. The reason for these specific ranges being preferred will be described below.

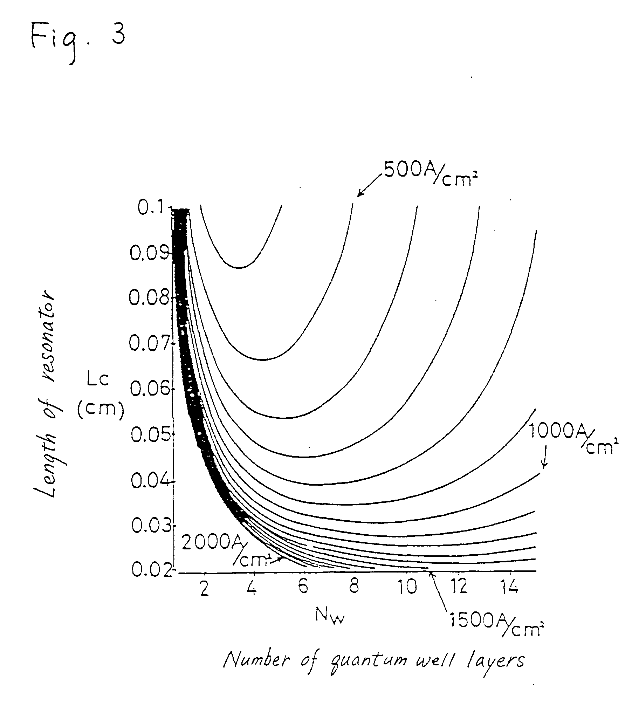

Figure **3** illustrates variation of threshold current densities as functions of the length $L_c$ of the resonator and the number $N_w$ of the quantum well layers, for semiconductor laser devices such as that obtained in Example 1 (i.e., quantum well semiconductor laser devices which are made of InGaAsP/InP type materials and have a pair of guide layers each having a GRIN-SCH structure). As a quantum well semiconductor laser device has larger number of quantum well layers, it can achieve larger gain for a fixed amount of injected carriers and thus have a lower threshold current density for laser oscillation. However, when the number of quantum well layers increases beyond a certain point, effect of the increased volume of those quantum well layers dominates the effect of the increased gain, and thus the threshold current density begins to increase again. In other words, a quantum well semiconductor laser device including a resonator of a fixed length has an optimum number with regard to its quantum well layers, by which the lowest threshold current density can be achieved. As can be seen from Figure **3** this optimum number increases as the resonator length $L_c$ decreases. This means that as a quantum well semiconductor laser device has larger number of quantum well layers, smaller resonator length becomes appropriate to achieve the lowest threshold current density.

With regard to quantum well semiconductor laser devices each having a varied resonator length $L_c$ and an optimum value for the number $N_w$ of quantum well layers to achieve the lowest of its threshold current density $J_{th}$, the number $N_w$ can be correlated respectively with the threshold current $I_{th}$, the differential quantum efficiency $\eta_d$ and the threshold current density $J_{th}$ according to the following formulae (II) through (IV):

$$I_{th} = [\, C_1 / (A_1 N_w - B_1)\,] + D_1 \qquad \text{(II)}$$

$$\eta_d = E_2 / [\, C_2 / (A_2 N_w - B_2) + D_2\,] \qquad \text{(III)}$$

$$J_{th} / N_w = A_3 \qquad \text{(IV)}$$

wherein $A_1$, $B_1$, $C_1$, $D_1$, $A_2$, $B_2$, $C_2$, $D_2$, $E_2$ and $A_3$ are constants.

It can be seen from the formulae (II) and (III) that as a quantum well semiconductor laser device has larger number of quantum well layers, it has a decreased threshold current $I_{th}$ and an increased differential quantum efficiency $\eta_d$.

On the other hand, when quantum well semiconductor laser devices each having a fixed $N_w$ value and a varied $L_c$ value are considered, increase in the resonator length $L_c$ leads to decrease in the threshold current density $J_{th}$ and thus to decrease in the threshold current density per each quantum well layer, which corresponds to $A_3$ in formula (IV). Therefore, as a quantum well semiconductor laser device has a longer resonator length, it can better reduce the above-mentioned overflow of injected carriers and thus shows more improved temperature characteristics enabling higher optical output even at high temperature.

When a quantum well semiconductor laser device has an excessively long resonator, however, effect of internal heat evolution becomes significant and thus the temperature within the device rises, resulting in deterioration of characteristics of the device. As described above, a quantum well semiconductor laser device having a smaller number of quantum well layers requires a longer resonator length in order to achieve the lowest threshold current density. Therefore, in view of reducing the undesired effect of heat evolution, a quantum well semiconductor device should have a larger number of quantum well layers, preferably more than 6, and more preferably more than 8.

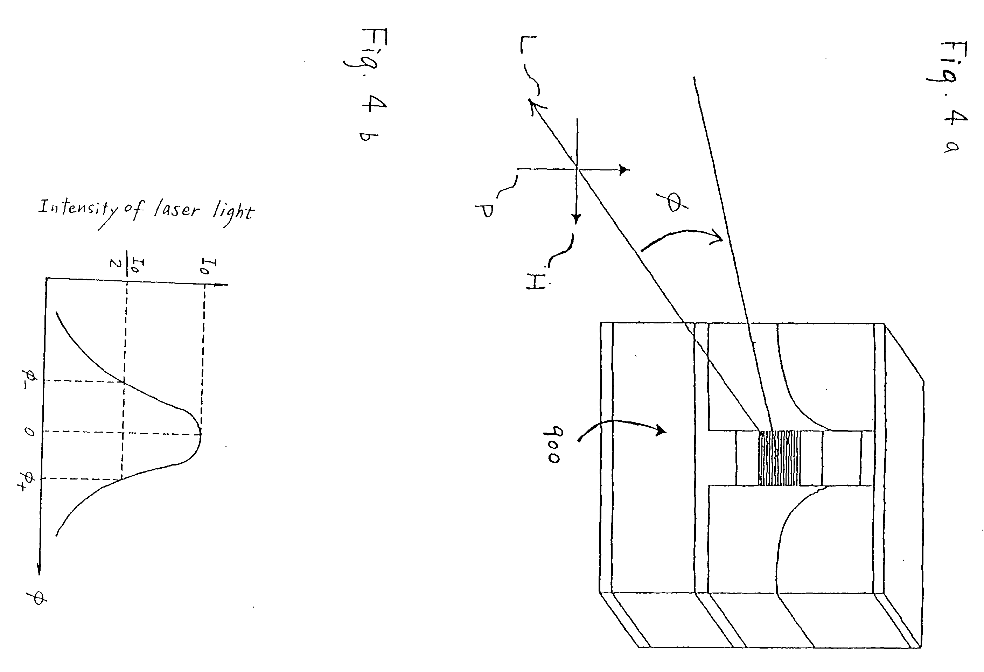

On the other hand, a quantum well semiconductor laser device having a larger number of quantum well layers has a more enlarged spreading angle θ when the spreading angle is measured in the direction perpendicular to the quantum well layers. Herein the spreading angle θ is determined in the manner as described with respect to Figures **4a** and **4b**. In Figure **4a**, an angle φ is the angle measured from a perpendicular vector **L** which is perpendicular to a light emitting face **900** of a semiconductor laser device such as shown in Example 1, and which represents the principal propagation direction of light emitted therefrom. A direction arrow **P** represents the direction perpendicular to the alignment of the quantum well layers of the device. A direction arrow **H** represents the direction horizontal to the alignment of the quantum well layers of the device. Figure **4b** illustrates a relationship between the angle φ and intensity of the emitted laser light. In Figure **4b**, $I_0$ represents the maximum intensity of the laser light and φ_ and φ_+ represent the angles where intensity of the emitted laser light becomes one half of $I_0$. The spreading angle θ is defined as the absolute value of (φ_+ - φ_).

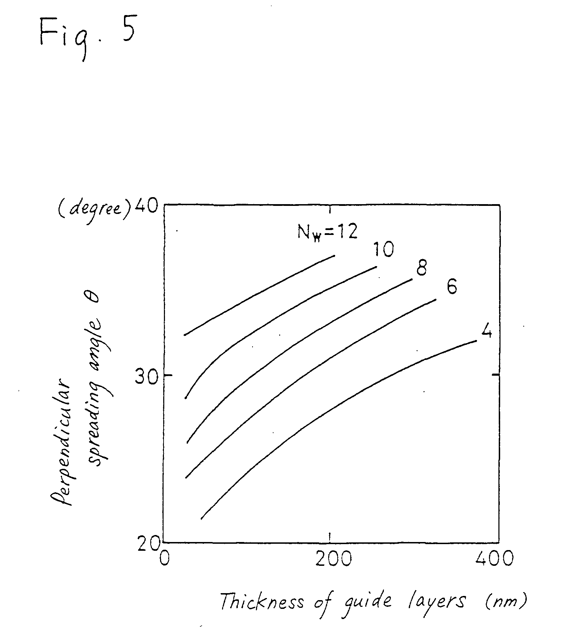

Figure **5** illustrates relationships between the perpendicular spreading angle θ (i.e., the spreading angle θ measured in the direction perpendicular to the quantum well layers, that is, in the plane containing arrow **P** and vector **L**) and the thickness of the guide layers for semiconductor laser devices having varied number of quantum well layers. Data shown in this graph are obtained from semiconductor laser devices which are made of InGaAsP/InP type materials and have first and second guide layers each having a GRIN-SCH structure and an equal thickness, as in the case of the device prepared in Example 1. As can be seen from Figure **5**, a larger number of quantum well layers is accompanied by a more enlarged perpendicular spreading angle θ. On the other hand, the horizontal spreading angle θ (i. e., the spreading angle θ of a quantum well semiconductor laser device measured in the direction horizontal to the quantum well layers, that is, in the plane containing arrow **H** and vector **L**) is generally known to be about 25°. Thus, by approximating the perpendicular spreading angle θ to 25°, the elliptic ratio (i.e., ratio of the perpendicular spreading angle to the horizontal spreading angle) can be closer to one (1), thereby enabling the semiconductor laser device to achieve higher coupling efficiency with an optical fiber and the like. The perpendicular spreading angle θ is preferably not more than 30°. Therefore, from Figure **5**, the number of quantum well layers is preferably not more than **10**.

It can be also seen from Figure **5** that even when the number of quantum well layers is small, such as $N_w$ = 4, an appropriate perpendicular spreading angle θ can be obtained by increasing the thicknesses of guide layers. However, excessive increase in the thicknesses of the guide layers is undesirable because it can result in reducing efficiency for injecting carriers into the quantum well layer placed between these guide layers. When a guide layer has a GRIN-SCH structure, the thicknesses thereof is preferably in the range of about 20 nm to about 200 nm.

As has been discussed above, in order to realize a low threshold current density and desirable temperature characteristics, and at the same time secure the perpendicular spreading angle θ within an appropriate range, a semiconductor laser device of this invention has the number of quantum well layers preferably in the range of 6 to 10. Also, in order to realize a low threshold current density and desirable temperature characteristics, and at the same time restrict the undesired internal heat evolution, a semiconductor laser device of this invention has the length of its resonator preferably in the range of 250 µm to 700 µm, and more preferably in the range of 250 µm to 400 µm.

The semiconductor laser device obtained in Example 1, which has nine (9) quantum well layers and the resonator length of 350 µm, shows excellent temperature characteristics at high temperature, as indicated by the characteristic temperature $T_0$ of 60 Kelvin(K), and provides optical output of sufficiently high intensity. In addition, this device has the perpendicular spreading angle θ of 30°, which falls within the above-mentioned desirable range.

As can be seen from the above example, the present invention provides a semiconductor laser device which has improved temperature characteristics and generates optical output of sufficiently high intensity even when operated at high temperature, and which can also realize high coupling efficiency with photo-receiving device such as an optical fiber and the like.

Various other modifications will be apparent to and can be readily made by those skilled in the art without departing from the scope of this invention. Accordingly, it is not intended that the scope of the invention be limited to the description as set forth herein, but rather by the appended claims.

## Claims

1. A semiconductor laser device having a resonator, the device comprising:

   a substrate (608); and

   a laminated structure formed on a top face of the substrate, the laminated structure including (a) first and second guide layers (602, 605) and (b) a quantum well structure of compound semiconductor interposed between the first and second guide layers, the quantum well structure serving as the resonator and including a plurality of quantum well layers (603) and a plurality of barrier layers (604) stacked in alternating manner;

   wherein the number of the quantum well layers (603) is in the range of 6 to 10, and the length (Lc) of the resonator is in the range of 250μm to 700μm;
   **characterised in that**
   the thicknesses of the first and second guide layers (602, 605) are selected so as to give laser light emitted from the device a perpendicular spreading angle in the range of about 25° to about 30°.

2. A device according to claim 1, wherein the first and second guide layers (602, 605) each have a Graded Index Separate Confinement Heterostructure.

3. A device according to claim 1, further comprising a current blocking layer (609, 610), and wherein the laminated structure has a stripe-shaped geometry and is placed in contact with the current blocking layer on the side faces of the stripe-shaped geometry.

4. A device as claimed in claim 1, 2 or 3 wherein the device is an InGaAsP semiconductor laser device.

## Patentansprüche

1. Halbleiterlaservorrichtung mit einem Resonator, umfassend:

   ein Substrat (608) und
   eine Laminat-Struktur, die auf einer Oberseite des Substrates ausgebildet ist, wobei die Laminat-Struktur (a) erste und zweite Führungsschichten (602, 605) und (b) eine Quantenwannenstruktur eines Verbindungshalbleiters, gelegen zwischen den ersten und zweiten Führungsschichten, umfasst und die Quantenwannenstruktur als der Resonator dient und eine Vielzahl von Quantenwannenschichten (603) und eine Vielzahl von Sperrschichten (604), in abwechselnder Weise gestapelt, umfasst,

   wobei die Anzahl der Quantenwannenschichten (603) im Bereich von 6 bis 10 liegt und die Länge ($L_c$) des Resonators im Bereich von 250 μm bis 800 μm ist,
   **dadurch gekennzeichnet, dass**
   die Dicken der ersten und zweiten Führungsschichten (602, 605) so gewählt sind, dass Laserlicht, das von der Vorrichtung emittiert ist, ein senkrechter Streuwinkel im Bereich von etwa 25° bis etwa 30° vermittelt ist.

2. Vorrichtung nach Anspruch 1, bei der die ersten und zweiten Führungsschichten (602, 605) jeweils eine Graded Index Separate Confinement Heterostructure bzw. gradierte Index-Trenn-Begrenzungs-Heterostruktur haben.

3. Vorrichtung nach Anspruch 1, weiterhin umfassend eine Stromsperrschicht (609, 610), wobei die Laminat-Struktur eine streifenförmige Geometrie hat und in Kontakt mit der Stromsperrschicht auf Seitenflächen der streifenförmigen Geometrie gebracht ist.

4. Vorrichtung nach Anspruch 1, 2 oder 3, bei der die Vorrichtung eine InGaAsP-Halbleiterlaservorrichtung ist.

## Revendications

1. Dispositif laser à semi-conducteur présentant un résonateur, le dispositif comprenant :

   un substrat (608) ; et
   une structure stratifiée, formée sur la face supérieure du substrat, laquelle structure stratifiée comprend (a) des première et deuxième couches de guidage (602, 605), et (b) une structure formant puits quantique en un semi-conducteur composite, intercalée entre les première et deuxième couches de guidage, la structure formant puits quantique servant de résonateur et comprenant plusieurs couches formant puits quantique (603) et plusieurs couches d'arrêt (604), selon un empilement alterné ;

dans lequel le nombre des couches formant puits quantique (603) est situé dans une fourchette de 6 à 10, et la longueur (Lc) du résonateur est comprise entre 250 μm et 700 μm ;

**caractérisé en ce que** les épaisseurs des première et deuxième couches de guidage (602, 605) sont sélectionnées de telle manière que la lumière laser, émise à partir du dispositif, ait un angle d'étalement perpendiculaire compris dans la plage d'environ 25° à environ 30°.

2. Dispositif selon la revendication 1, dans lequel les première et deuxième couches de guidage (602, 605) ont chacune une hétérostructure de confinement séparé à gradient d'indice.

3. Dispositif selon la revendication 1, comprenant en outre une couche d'arrêt de courant (609, 610), et dans lequel la structure stratifiée présente une géométrie en forme de bande et est placée en contact avec la couche d'arrêt de courant, sur les faces latérales de la géométrie en forme de bande.

4. Dispositif selon la revendication 1, 2 ou 3, dans lequel le dispositif est un dispositif laser à semi-conducteur au InGaAsP.

Fig. 1

Fig. 2

Conduction band / Valence band energy diagram with labels 701, 702, 703, 704, 705, 706, 707.

Fig. 3

Fig. 4 a

900

Fig. 4 b

Fig. 5

Fig. 6